# EUROPEAN PATENT APPLICATION

(11) **EP 1 122 992 A1**
(43) Date of publication of application: **08.08.2001**
(21) Application number: 00102332.4
(22) Date of filing: 03.02.2000
(51) Int. Cl.: H05K 9/00

(54) **Method and apparatus for providing EMI-sealing between a cabinet opening and a closure means for closing said opening**

(71) Applicant: TELEFONAKTIEBOLAGET LM ERICSSON, 126 25 Stockholm (SE)
(72) Inventor: Knutsson, Hans, 7620 Lernvig (DK)
(74) Representative: Roerboel, Leif

(57) **Abstract**

In a construction for providing EMI-shielding between a cabinet opening and a closure means for closing said opening, the necessary electrical contact between the cabinet (2) and the closure means (1) respectively is provided by forming spring-like formations (9,10) in one piece with and out of the edge part of the closure means (1). With this arrangement no separate spring-like formations or gaskets or the like will have to be mounted on the closure means (1), whereby the EMI-sealing is provided in a more efficient and economical manner.

## Description

### TECHNICAL FIELD

The present invention relates to a method and an apparatus for providing EMI-sealing between a cabinet opening and a closure means for closing said opening, said cabinet and said closure means having EMI-shielding properties.

### BACKGROUND ART

In such constructions it is known to produce the sealing and electrical contact along the edges of the closure means by means of separately provided electrically conductive gaskets, contact springs, etc., which are mounted along the edges of the closure means or the cabinet opening for resiliently providing electrical contact across the gap between the closure means and the cabinet opening, when the closure means is in a closing position. Such constructions are e.g. known from US-4,762,966, US-4,761,516 and US-4,717,791.

### DISCLOSURE OF THE INVENTION

It is an object of the present invention to provide a method and an apparatus of the kind referred to above, with which it is possible to provide said EMI-sealing in a more efficient and economical manner, and this object is in accordance to the present invention achieved by forming spring-like formations in one piece with and out of the edge part of the closure means. With this arrangement no separate gaskets, contact springs or the like have to be mounted in order to provide the necessary EMI-sealing along the edges of the closure means.

In a preferred embodiment of the invention the closure means comprises a supporting frame, whereby the closure means can be made from a relatively thin plate of EMI-shielding material, which does not as such have the required rigidity to stabilise the closure means.

The frame structure may advantageously be provided in plastic material and may be composed of separate parts to be clipped together around the closure plate and the frame structure may comprise hinges or clip-on formations to be connected to corresponding formations on the cabinet.

Preferably the plate of EMI-shielding material for the closure means is made from metal and more preferred steel, with a preferred thickness less than 0.3 mm.

### BRIEF DESCRIPTION OF THE DRAWINGS

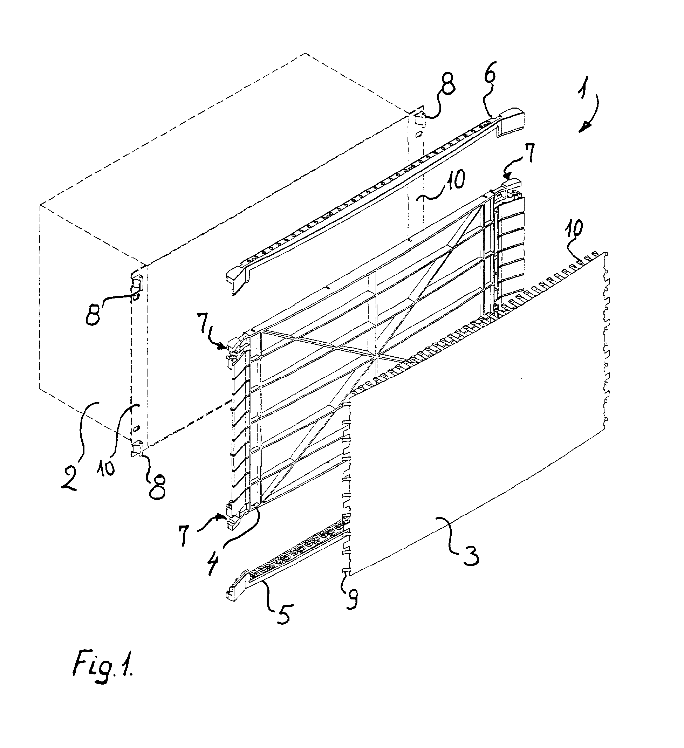

In the following detailed part of the present description the invention will be explained in more detail with reference to the exemplary preferred embodiment of an apparatus for providing EMI-sealing between a cabinet opening and a closure means for closing said opening according to the invention shown in the drawing, in which
Figure 1 shows an exploded view of a closure means and a cabinet to be closed thereby in accordance with a preferred embodiment of the invention.

### DESCRIPTION OF THE PREFERRED EMBODIMENT

The construction shown in Figure 1 is intended to provide EMI-sealing between a cabinet 2 opening and a closure means 1 for closing said opening. The closure means 1 comprises a thin metal plate 3 and a frame structure 4 for supporting the thin metal plate 3. The metal plate 3 is mounted on the frame structure 4 by means of a bottom rail 5 and a top rail 6, which are clipped on to the frame structure 4 when the metal plate 3 is positioned onto the frame structure 4. The metal plate 3 comprises spring-like formations 9,10 along the edges of the metal plate 3, said spring-like formations 9,10 being formed out of the metal plate 3 by punching and bending edge parts thereof. The frame structure 4 further comprises hinges or clip-on formations 7 for connecting to corresponding formations 8 on the cabinet 2. Said formations 7,8 may be formed as clip-on formations or as hinges providing a possibility of clip-on or hinged closing of the opening in the cabinet 2 by means of the closure means 1.

When the closure means 1 is brought into a closing position on the cabinet 2, the spring-like formations 9,10 are brought into engagement with the cabinet 2 and provide electrical contact between the cabinet 2 and the metal plate 3. The electrical contact between the spring-like formations 10 and the cabinet 2 is provided by sliding engagement between the spring-like formations 10 and the inside of the top plate and bottom plate of the cabinet 2. The corresponding electrical contact between the spring-like formations 9 and the cabinet 2 is provided by resilient engagement between the spring-like formations 9 and the front flanges 10 on the cabinet 2.

The number of spring-like formations 9,10 and the corresponding distance between neighbouring spring-like formations will have to be dimensioned in accordance with the desired level of EMI-sealing to be provided between the closure means 1 and the cabinet 2 opening.

Although the invention has been described in connection with the preferred embodiment shown in Fig. 1, it will be evident for a man skilled in the art, that several modifications are possible within the scope of the following claims, such as providing the closure means 1 from other materials, e.g. conductive plastic material, where the spring-like formations 9,10 are provided integrally with said closure means 1.

## Claims

1. Method for providing EMI-sealing between a cabinet (2) opening and a closure means (1) for closing said cabinet (2) opening, said cabinet (2) and said closure means (1) having EMI-shielding properties, said method comprising the steps of
- providing electrical contact between the cabinet (2) and the closure means (1) respectively, by, along the edges of the closure means, providing a plurality of electrically conductive spring-like formations, resiliently providing electrical contact across a gap between the closure means in a closing position and the cabinet opening,
**characterised** by further comprising the steps of
- forming said spring-like formations (9,10) in one piece with and out of the edge part of the closure means (1).

2. Method in accordance with claim 1, **characerised** by further comprising the step of providing a frame (4) for supporting the closure means (1).

3. Method in accordance with claim 2, **characterised** by further comprising the step of providing said frame (4) with hinge means (7,8) for providing a hinged closure arrangement.

4. Method in accordance with claim 2, **characterised** by further comprising the step of providing said frame with clip-on means (7,8) for providing a clip-on closure arrangement.

5. Apparatus for providing EMI-sealing between a cabinet (2) opening and a closure means (1) for closing said cabinet (2) opening, said cabinet (2) and said closure means (1) having EMI-shielding properties, said apparatus comprising a plurality of electrically conductive spring-like formations positioned along the edges of the closure means (1) for resiliently providing electrical contact across a gap between the cabinet (2) and the closure means (1) in a closing position thereof,
**characterised** by
said spring-like formations (9,10) being provided in one piece with and out of the material of the edge part of the closure means (1).

6. Apparatus in accordance with claim 5, **characterised** by said closure means (1) further comprising a frame (4) for supporting the closure means (1).

7. Apparatus in accordance with claim 6, **characterised** by said frame (4), comprising hinge and/or clip-on means (7) for connecting to corresponding formations (8) on the cabinet (2).

8. Apparatus in accordance with claim 6 or 7, **characterised** by said frame (4) comprising a main frame (4), a top frame (6) and a bottom frame (5), said top and bottom frames (5,6) being provided with clip-on means in order to be clipped on to the main frame (4) and securing a main surface (3) of the closure means (1) to said main frame (4).

9. Apparatus in accordance with claim 6, 7 or 8, **characterised** by said closure means (1) comprising a thin plate (3) of EMI-shielding material.

10. Apparatus in accordance with claim 9, **characterised** by said thin plate (3) being a metal plate (3), the spring-like formations (9,10) being provided by punching and bending edge parts thereof.

11. Apparatus in accordance with claim 9, **characterised** by said metal plate (3) being a steel plate.

12. Apparatus in accordance with claim 10 or 11, **characterised** by the thickness of said metal plate (3) being less than approximately 0.3 mm.
